# EUROPÄISCHE PATENTSCHRIFT

(11) **EP 0 557 813 B1**
(45) Veröffentlichungstag und Bekanntmachung des Hinweises auf die Patenterteilung: **02.09.1998**
(21) Anmeldenummer: 93102200.8
(22) Anmeldetag: 12.02.1993
(51) Int. Cl.: G06F 12/02

(54) **Digitales Sprachspeichersystem für ein Telekommunikationssystem**
System of digital-speech-memory for a telecommunication system
Système numérique de mémorisation du langage pour un système de télécommunication

(30) Priorität: 19.02.1992 DE 4204929
(43) Veröffentlichungstag der Anmeldung: 01.09.1993
(73) Patentinhaber: ALCATEL ALSTHOM COMPAGNIE GENERALE D'ELECTRICITE, 75008 Paris (FR)
(72) Erfinder: Dvorak, Susanne, W-7144 Asperg (DE); Ackermann, Uwe, W-7141 Freiberg (DE); Kopp, Dieter, W-7254 Hemmingen (DE); Hörmann, Thomas, W-7141 Grossbottwar 2 (DE)
(74) Vertreter: Pohl, Herbert, Dipl.-Ing.

(56) Entgegenhaltungen:
- DE-A- 3 518 737
- DE-A- 3 632 341
- DE-A- 4 013 395

## Beschreibung

Die Erfindung betrifft ein digitales Sprachspeichersystem mit Halbleiterspeicher mit wahlfreiem Zugriff zur Nachrichtenspeicherung in einem Telekommunikationssystem.

Bereits bekannt sind z.B. Telefonanrufbeantworter, bei denen Nachrichten analog oder digital auf Magnetbändern gespeichert werden. Dabei wird sequentiell gespeichert und ausgelesen. Sofern ein Löschen einzelner Nachrichten möglich ist, werden dabei entstehende Lücken erst wieder zum Speichern neuer Nachrichten genutzt, nachdem das gesamte Band gelöscht ist.

Anstelle von Magnetbändern werden heute auch Halbleiterspeicher, meist DRAM's zur Sprachspeicherung verwendet (siehe z.B. Aufsatz von Schartel, Ingolf: "Mein Telefon spricht mit mir". Funkschau 13, 15.7.1990, Spezial S. 24-27).

Halbleiterspeicher können, im Gegensatz zu Magnetbandspeichern, auf einfache Weise partiell ausgelesen und gelöscht werden, wenn eine entsprechende Adressierung der Nachrichten beim Abspeichern vorgesehen wird. Da einerseits das Abspeichern von Sprache großen Speicherbedarf erfordert, andererseits bei Halbleiterspeichern meist nur ein begrenzter Speicherplatz zur Verfügung steht, ist dessen optimale Nutzung anzustreben. Dazu werden z.B. Sprachdaten nach speziellen Verfahren reduziert, wie in einem Aufsatz von Gfeller, Bruno mit dem Titel: ,,Tritel Guardia, das Telefon mit digitalem Anrufbeantworter" in ascom, Technische Mitteilungen 1/91, S.38-40 beschrieben.

In der Offenlegungsschrift DE-A-36 32 341 wird eine Sprachausgabeeinheit für eine digitale Vermittlungsstelle beschrieben, mit einem teilweise aus Schreib-Lese-Speichern aufgebauten Sprachelementpeicher, in dem Sprachelemente gespeichert sind. Die Ausgabe eines fortlaufenden Textes erfolgt durch eine Textausgabesteuerung mittels eines Programmes, welches aus den Anfangsadressen der nacheinander auszugebenden Sprachelemente besteht. Die Sprachausgabeeinheit erlaubt auch die Änderung von Sprachelementen zur Abspeicherung einer begrenzter Anzahl von Namen, wobei die Adressierung einer zu ändernden Speicherzelle von der Textausgabesteuerung erfolgt.

Eine Nutzung unterschiedlich großer freier oder verfügbar gewordener Speicherbereiche zur erneuten Speicherung von Nachrichten vor einer Gesamtlöschung des Speichers ist in den genannten Veröffentlichungen nicht erwähnt.

Der Erfindung liegt die Aufgabe zugrunde, ein einfaches und kostengünstiges Sprachspeichersystem zu entwickeln, bei dem der Speicher möglichst gut genutzt wird.

Diese Aufgabe wird durch die in Anspruch 1 angegebenen Merkmale gelöst.

Der begrenzt vorhandene Speicher wird hier mit relativ geringem Aufwand optimal genutzt. Es können mehrere Nachrichten unterschiedlicher Länge abgespeichert und wieder ausgelesen werden, wobei auch nicht zusammenhängende Speicherbereiche, die nach dem Auslesen oder Löschen von Nachrichten wieder verfügbar werden, sofort wieder zum Speichern von Nachrichten verwendet werden können.

Weiterbildungen der Erfindung ergeben sich aus den Unteransprüchen. So ermöglicht es die in Anspruch 2 beschriebene Weiterbildung, fehlerhafte Speichersegmente von der Benutzung auszuschließen. Dadurch bleibt die Speicherung und Wiedergabe von Nachrichten, auch wenn fehlerhafte Speicherelemente vorhanden sind, frei von Beeinträchtigungen, welche sonst bei Überschreiten bestimmter Fehlerraten hörbar werden oder zu Ausfällen führen könnten.

Eine in Anspruch 3 beschriebene Ausgestaltung der Erfindung ermöglicht die zusätzliche Ein- und Ausgabe von Texten. Damit können Anrufe durch Ausgabe eines vorbereiteten Textes beantwortet werden. Anstelle von gesprochenen Nachrichten können auch von anrufenden Teilnehmern übertragene Texte abgespeichert und wiedergegeben werden.

Das digitale Sprachspeichersystem ist besonders für die Verwendung in Telefonanrufbeantwortern oder Telefonapparaten mit integriertem Anrufbeantworter geeignet, entsprechend dem Anspruch 4 sind jedoch auch weitere vorteilhafte Kombinationen mit anderen Endgeräten in Telekommunikationssystemen, wie z.B. Faxgeräten möglich.

Weitere Einsatzmöglichkeiten des Sprachspeichersystems ergeben sich aus Anspruch 5. Danach ist es beispielsweise in digitalen Fernsprechnebenstellenanlagen (PBX) sinnvoll nicht jedes Endgerät mit einem Sprachspeichersystem auszustatten, sondern einen Sprachspeicher, der von mehreren Endgeräten gemeinsam genutzt wird, zu installieren.

Die in Anspruch 6 beschriebene Lösung ermöglicht es, z.B. bei ISDN-Anlagen, die Rufnummern oder die Namen von Anrufern in Verbindung mit den jeweils übermittelten Nachrichten aufzuzeichnen. Dadurch kann z.B. bei der Wiedergabe von Nachrichten ein gezielter Zugriff auf Nachrichten bestimmter Anrufer anhand einer Liste gespeicherter Rufnummern oder Namen von Anrufern erfolgen.

Im folgenden wird die Erfindung anhand eines Ausführungsbeispiels und mit Hilfe eines Diagramms näher erläutert.

Ein digitales Sprachspeichersystem besteht aus einem Sprachmodul in Verbindung mit einer Speichersteuerung und einem Halbleiterspeicher 1. Das Sprachmodul sorgt für die Digitalisierung analoger Signale zur anschließenden Weiterverarbeitung und für deren Rückwandlung zur Wiedergabe von Nachrichten. Die Speichersteuerung ist durch einen Mikroprozessor realisiert, es sind aber auch ASIC's oder diskret aufgebaute Schaltungen mit digitalen Bauelementen verwendbar. Der Halbleiterspeicher 1 besteht aus DRAM's, ebenso können auch SRAM's verwendet werden.

Der Halbleiterspeicher ist in n einzeln adressierbare, gleich große Segmente mit jeweils mehreren Bytes Speicherplatz aufgeteilt. Ein Verzeichnis 2 verfügbarer Speichersegmente und eine Startadressenliste 3 sind in einem dafür reservierten Teil des Halbleiterspeichers 1 oder in einem separaten Speicher vorhanden.

Das Diagramm zeigt den Inhalt von Speichersegmenten des Halbleiterspeichers 1, das Verzeichnis 2 der verfügbaren Speichersegmente und die Startadressenliste 3, nachdem mehrere Nachrichten aufgezeichnet und ein Teil davon wieder gelöscht wurden. Die Speichersegmente 1, 2, 3, 10 ... im Halbleiterspeicher sind frei, d.h. sie enthalten keine Daten oder aber Daten, die überschrieben werden können. Solche Speichersegmente stehen zum Speichern weiterer Nachrichten zur Verfügung. Ihre Adressen sind deshalb im Verzeichnis 2 der verfügbaren Speichersegmente vermerkt.

Die Speichersegmente 4, 5, 6, 7, 9 ... im Halbleiterspeicher 1 enthalten Daten. Diese bestehen aus einem Datenblock als Teil einer zuvor aufgezeichneten Nachricht und aus der Adresse desjenigen Speichersegments, in dem sich der nächste Datenblock dieser Nachricht befindet. Beispielsweise ist in Speichersegment 4 ein Datenblock der Nachricht 0 enthalten. Der nächstfolgende Datenblock dieser Nachricht befindet sich im Speichersegment 11, dessen Adresse im Speichersegment 4 mit enthalten ist. Die Startadressenliste 3 enthält die Adressen derjenigen Speichersegmente, in denen sich der jeweils zuerst abgespeicherte Datenblock einer Nachricht befindet. Über diese Startadressen können die einzelnen Nachrichten abgerufen werden.

Die Nachricht 0 wurde bei ihrer Aufzeichnung, in fünf Datenblöcke aufgeteilt, in den Speichersegmenten 4, 11, 12, 13, 21 abgespeichert.

Die Startadressenliste 3 verweist deshalb auf das Speichersegment 4 als Startadresse. Der im Speichersegment 4 gespeicherte erste Datenblock der Nachricht 0 wird zuerst ausgelesen. Daran anschließend wird der nächste Datenblock, dessen Adresse 11 im vorhergehenden Speichersegment 4 vermerkt ist, aus Segment 11 ausgelesen. Es folgen die Datenblöcke aus den Speichersegmenten 12, 13, 21, die gleichermaßen über die im jeweils vorhergehenden Speichersegment gespeicherten Adressen des jeweils nächsten Speichersegments miteinander verkettet sind. Nach Auslesen des letzten Datenblocks, in diesem Falle aus dem Speichersegment 21, wird die Wiedergabe der Nachricht 0 durch eine Kodierung beendet, die hier anstelle der Adresse eines nächsten Speichersegmentes das Ende der Nachricht markiert.

Das Aufzeichnen einer Nachricht wird wie folgt durchgeführt:

Die Abspeicherung z.B. einer Nachricht 4 beginnt im Speichersegment 1, dem ersten freien Speichersegment, welches im Verzeichnis verfügbarer Speichersegmente eingetragen ist. Diese Adresse wird gleichzeitig als Startadresse von Nachricht 4 in die Startadressenliste eingetragen. Sobald eine einem Datenblock entsprechende Datenmenge dieser Nachricht gespeichert ist, wird die Abspeicherung im Speichersegment 2 fortgesetzt. Dieses ist das Nächstfolgende der im Verzeichnis 2 eingetragenen verfügbaren Speichersegmente. Analog erfolgt die weitere Abspeicherung in den nächsten Speichersegmenten entsprechend deren Reihenfolge im Verzeichnis 2 verfügbarer Speichersegmente. Die Adresse des jeweils nächsten Speichersegments wird im vorhergehenden Speichersegment mit abgespeichert, die Adresse von Speichersegment 2 somit in Speichersegment 1 vermerkt. Ebenso wird die Adresse von Speichersegment 3 im Speichersegment 2 vermerkt. Die Adressen der beim Speichern belegten Speichersegmente werden im Verzeichnis 2 der verfügbaren Speichersegmente gelöscht, in diesem Falle die Adressen der Speichersegmente 1, 2, 3. Im letzten zum Speichern der Nachricht 4 genutzten Speichersegment 10 wird anstelle der Adresse des nächsten Speichersegments die Codierung für das Ende der Nachricht eingetragen. Die Länge einer Nachricht kann entweder vorab festgelegt sein, z.B. durch Zuteilung einer Sprechzeit vorgegebener Dauer, oder sie kann ohne Begrenzung bleiben. Im letzteren Fall wird das Ende einer Nachricht durch die folgende Sprachpause markiert, die die Aufnahme einer Ende-Codierung in den Sprachspeicher veranlaßt. Eine solche Ende-Codierung kann auch für den Fall vorgesehen werden, daß eine Sprechzeit vorgegebener Dauer für jede Nachricht festgelegt ist, diese jedoch nicht voll ausgenutzt wird. Dadurch besteht dann die Möglichkeit, den jeweils nicht ausgenutzten Speicherplatz anderweitig zu nutzen.

Beim Löschen einer gespeicherten Nachricht werden die Adressen der mit Datenblöcken dieser Nachricht belegten Speichersegmente wieder in das Verzeichnis 2 verfügbarer Speichersegmente eingetragen. Die Startadresse der Nachricht wird in der Startadressenliste 3 gelöscht. Im Falle der Löschung der im Diagramm 1 enthaltenen Nachricht 2 würden die Speichersegmente 5, 6, 7 in das Verzeichnis 2 verfügbarer Speichersegmente eingetragen und die Startadresse des Speichersegments 5 in der Startadressenliste 3 gelöscht.

Im Diagramm 1 sind die Segmente 8, 17, 18 nicht im Verzeichnis 2 enthalten, jedoch auch nicht zum Speichern einer Nachricht benutzt worden. Ein solcher Fall liegt vor, wenn beim Initialisieren des Systems die Speichersegmente 8, 17, 18 als mit Fehlern behaftet erkannt wurden und deswegen nicht in das Verzeichnis eingetragen und damit von der weiteren Benutzung ausgenommen wurden.

Üblicherweise werden in einem Sprachspeicher z.B. eines Anrufbeantworters gespeicherte Nachrichten entsprechend der Reihenfolge ihres Einganges ausgegeben. Hierzu werden die in der Startadressenliste 3 aufgezeichneten Startadressen der Reihe nach abgearbeitet. Dies kann z.B. durch wiederholte Betätigung einer Abruftaste erfolgen. Eine weitere Möglichkeit ist eine Eingabe von Nummern, die den gespeicherten Nachrichten, entsprechend der Reihenfolge ihres Eintreffens, zugeordnet und im Speicher zusammen mit der jeweiligen Startadresse der Nachricht abgelegt werden und deren Eingabe die Ausgabe der unter der zugehörigen Startadresse jeweils abgespeicherten Nachricht auslöst.

Wird das Sprachspeichersystem in einem Kommunikationsnetz betrieben, in dem z.B. innerhalb der Signalisierunginformation Teilnehmernummern oder -namen übertragen werden, so können diese anstelle von Nachrichtennummern mit den Startadressen der einzelnen Nachrichten abgespeichert werden. Die einzelnen Nachrichten lassen sich dann über die mit abgespeicherte Teilnehmernummer oder den mit abgespeicherten Teilnehmernamen abrufen. Hierzu kann eine Liste der gespeicherten Teilnehmernummern oder -namen auf einem Display eines Endgerätes angezeigt werden.

Sollen anstelle von Sprachnachrichten Texte abgespeichert werden, so kann dies auf gleiche Art und Weise wie vorstehend für Sprachnachrichten beschrieben, geschehen. Zur Ausgabe solcher Texte ist ein im Endgerät eingebautes Display, ein mit dem Sprachspeichersystem gekoppeltes Datensichtgerät oder ein Drucker geeignet.

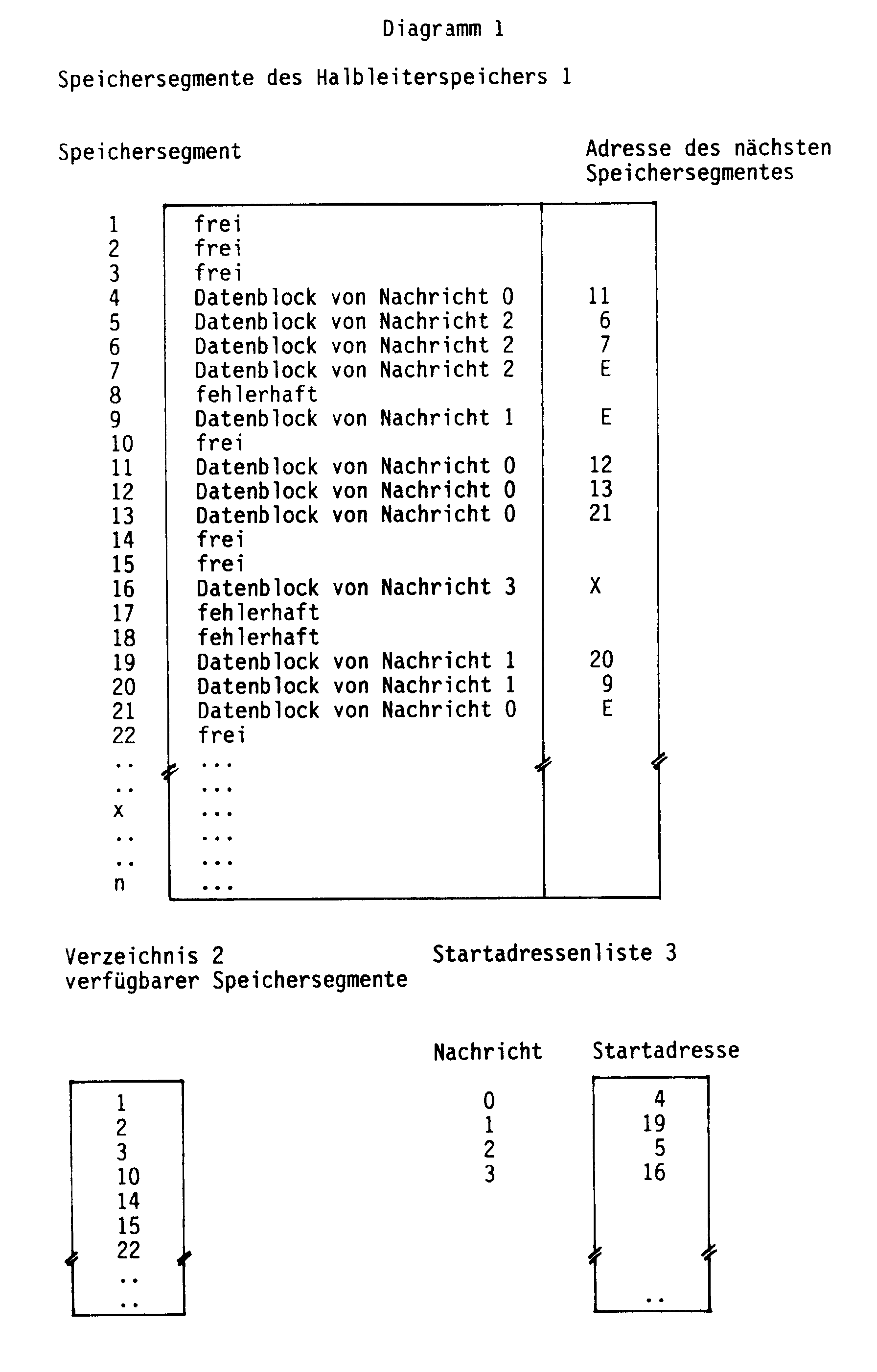

## Patentansprüche

1. Digitales Sprachspeichersystem zur Nachrichtenspeicherung in einem Telekommunikationssystem, mit
- einem Halbleiterspeicher mit wahlfreiem Zugriff, der in einzeln adressierbare Segmente aufgeteilt ist, und mit
- einer Sprachsteuerung, die auszugebende Nachrichten über ihnen jeweils zugeordnete Startadressen aufruft,
**dadurch gekennzeichnet**, daß die Sprachsteuerung eine Vorrichtung hat die
- die Adressen von zur Datenspeicherung aktuell verfügbaren Speichersegmenten in ein Verzeichnis einträgt und bei Wegfall der Verfügbarkeit aus dem Verzeichnis löscht und die
- aus abzuspeichernden Nachrichten ein oder mehrere an die Größe der Speichersegmente angepaßte Datenblöcke bildet, diese in den verfügbaren Speichersegmenten ablegt, dabei die Adresse des zum Abspeichern des ersten Datenblocks einer Nachricht benutzten Speichersegments als Startadresse in eine Startadressenliste und die Adressen des nachfolgend benutzten Speichersegments und aller weiteren benutzten Speichersegmente im jeweils vorausgehenden Speichersegment vermerkt und das Ende einer Nachricht durch eine Codierung im letzten für diese Nachricht verwendeten Speichersegment kennzeichnet.

2. Digitales Sprachspeichersystem nach Anspruch 1, dadurch gekennzeichnet, daß die Speichersteuerung bleibende Fehler in den einzelnen Speichersegmenten erkennt und die Adressen fehlerbehafteter Speichersegmente im Verzeichnis der verfügbaren Speichersegmente löscht.

3. Digitales Sprachspeichersystem nach Anspruch 1 oder 2, dadurch gekennzeichnet, daß das Sprachspeichersystem zusätzlich Textdaten verarbeitet und hierzu mit mindestens einer Texteingabe- und mindestens einer Textausgabeeinrichtung verbunden ist.

4. Digitales Sprachspeichersystem nach einem der Ansprüche 1 bis 3, dadurch gekennzeichnet, daß es Teil eines Endgerätes für Sprach-, Text- oder Bildkommunikation ist.

5. Digitales Sprachspeichersystem nach einem der Ansprüche 1 bis 3, dadurch gekennzeichnet, daß es mehreren Endgeräten für Sprach-, Text- oder Bildkommunikation zugeordnet ist.

6. Digitales Sprachspeichersystem nach einem der Ansprüche 1 bis 5, dadurch gekennzeichnet,
daß das Sprachspeichersystem in der Lage ist, mit einem Anruf verbundene Signalisierungsinformation aufzunehmen und zusammen mit einer dabei übermittelten Nachricht abzuspeichern, und
daß der Zugriff auf zusammen mit Signalisierungsinformation abgespeicherte Nachrichten über diese Signalisierungsinformation erfolgen kann.

## Claims

1. Digital speech storage system for message storage in a telecommunications system, comprising
- a random-access semiconductor memory which is divided up into addressable segments, and comprising
- a speech control system which retrieves the messages to be outputted by means of their respective assigned starting addresses,
characterized in that the speech control system has a device which
- enters the addresses of memory segments currently available for data storage in a list and, when the availability is lost, erases them from the list and which
- forms, from messages to be stored, one or more data blocks matched to the size of the memory segments, stores said data blocks in the available memory segments, recording the addresses of the memory segment used to store the first data block of a message as the starting address in a starting address list and the addresses of the memory segments used subsequently and all further memory segments used in the respective preceding memory segment and characterizing the end of a message by a coding in the last memory segment used for said message.

2. Digital speech storage system according to Claim 1, characterized in that the storage control system detects permanent errors in the individual memory segments and erases the addresses of defective memory segments in the list of available memory segments.

3. Digital speech storage system according to Claim 1 or 2, characterized in that the speech storage system additionally processes text data and, for this purpose, is connected to at least one text input device and at least one text output device.

4. Digital speech storage system according to one of Claims 1 to 3, characterized in that it is part of a terminal appliance for speech, text or picture communication.

5. Digital speech storage system according to one of Claims 1 to 3, characterized in that it is assigned to a plurality of terminal appliances for speech, text or picture communication.

6. Digital speech storage system according to one of Claims 1 to 5, characterized in that the speech storage system is capable of recording signalling information connected to a call and of storing it together with a message transmitted at the same time, and in that the access to messages stored together with signalling information can be carried out by means of said signalling information.

## Revendications

1. Système numérique de mémorisation de langage pour mémoriser des messages dans un système de télécommunication, comprenant
- une mémoire à semi-conducteur à accès aléatoire, qui est divisée en segments adressables individuellement et appelle par
- une commande vocale les messages à émettre par l'intermédiaire d'adresses qui leur sont attribuées respectivement,
caractérisé en ce que la commande vocale est équipée d'un dispositif qui
- mémorise dans un répertoire les adresses à partir de segments de mémoire dispcnibles actuellement pour la mémorisation de données et les efface du répertoire en cas d'indisponibilité, et qui,
- à partir de messages à mémoriser, forme un ou plusieurs blocs de données adaptés à la taille des segments de mémoire, les place dans les segments de mémoire disponibles, en notant l'adresse du segment de mémoire utilisé pour mémoriser le premier bloc de données d'un message en tant qu'adresse de départ dans une liste d'adresses de départ, et en notant les adresses du segment de mémoire utilisé ensuite et de tous les autres segments de mémoire utilisés dans le segment de mémoire respectivement précédent, et en marquant la fin d'un message par un codage dans le dernier segment de mémoire utilisé pcur ce message.

2. Système numérique de mémorisation de langage selon la revendication 1, caractérisé en ce que la commande de mémoire reconnaît des erreurs permanentes dans les segments de mémoire individuels et efface les adresses de segments de mémoire défectueux du répertoire des segments de mémoire disponibles.

3. Système numérique de mémorisation de langage selon la revendication 1 cu 2, caractérisé en ce que le système de mémorisation de langage traite en outre des données de texte et est associé à cet effet au moins à un dispositif de saisie de texte et au moins à un dispositif de sortie de texte.

4. Système numérique de mémorisation de langage selon l'une quelconque des revendications 1 à 3, caractérisé en ce qu'il fait partie d'un terminal pour la communication par le langage, le texte ou l'image.

5. Système numérique de mémorisation de langage selon l'une quelconque des revendications 1 à 3, caractérisé en ce qu'il est attribué à plusieurs terminaux pour la communication par le langage, le texte ou l'image.

6. Système numérique de mémorisation de langage selon l'une quelconque des revendications 1 à 5, caractérisé en ce que le système de mémorisation de langage est en mesure de mémoriser des informations de signalisation associées à un appel et de les mémoriser en même temps qu'un message transmis alors, et en ce que l'accès aux messages mémorisés en même temps que des informations de signalisation peut s'effectuer par l'intermédiaire de ces informations de signalisation.
